# EUROPEAN PATENT SPECIFICATION

(11) **EP 1 252 623 B1**
(45) Date of publication and mention of the grant of the patent: **20.10.2004**
(21) Application number: 01904236.5
(22) Date of filing: 05.02.2001
(51) Int. Cl.: G11B 7/00

(54) **METHOD FOR THE DISTRIBUTION OF DATA MARKS ON A MEDIUM, AND METHOD AND APPARATUS FOR THE HOLOGRAPHIC RECORDING AND READOUT OF DATA**
VERFAHREN ZUM VERTEILEN VON DATENMARKEN AUF EINEM MEDIUM, UND VERFAHREN UND VORRICHTUNG ZUM HOLOGRAPHISCHEN AUFZEICHNEN UND LESEN VON DATEN
PROCEDE DE REPARTITION DE MARQUES DE DONNEES SUR UN SUPPORT, ET PROCEDE ET DISPOSITIF POUR L'ENREGISTREMENT HOLOGRAPHIQUE ET LA LECTURE DE DONNEES

(30) Priority: 04.02.2000 HU 0000518
(43) Date of publication of application: 30.10.2002
(60) Divisional application: 04014384.4
(73) Proprietor: Bayer Innovation GmbH, 40225 Düsseldorf (DE)
(72) Inventor: SZARVAS, Gábor, H-1033 Budapest (HU); Lörincz Emöke, H-1118 Budapest (HU); RICHTER, Péter, H-2092 Budakeszi (HU); KOPPA, Pál, H-2040 Budaörs (HU); ERDEI, Gábor, H-1111 Budapest (HU); FODOR, Jòzsua, H-1119 Budapest (HU); KALLO, Péter, H-1025 Budapest (HU); SÜTO, Attila, H-1047 Budapest (HU); DOMJAN, Lászlò, H-1112 Budapest (HU); UJHELYI, Ferenc, H-7030 Paks (HU)
(74) Representative: Bokor, Tamas
(86) International application number: PCT/HU2001/000011
(87) International publication number: WO 2001/057859

(56) References cited:
- EP-A- 0 534 616
- EP-A- 0 817 201
- WO-A-99/57719
- US-A- 4 149 269
- US-A- 5 550 779
- US-A- 5 754 520
- US-A- 5 808 998

## Description

### Technical Field

The invention relates to a method for the distribution of data marks on a medium, and the readout of the data in optical recording. The method of the invention may be applied where data coded with data marks having at least two states are generated with a data source having a two-dimensional matrix structure, and the image of the data source is recorded on an optical medium, during readout the image of the data source is regenerated with an optical method, the regenerated image is detected with a two-dimensional detector, and the data is read out from the regenerated image with the help of identifying marks on the detected image.

The invention also concerns an improved method and apparatus for the holographic recording and readout of data. This method is of the type wherein an image of a two-dimensional data source is recorded in a hologram on an optical medium, where the hologram is resulting from an interference between an object beam and reference beam in a Fourier-plane associated to the image of the data source (the focal plane of the imaging system), and the recorded hologram is detected with a two-dimensi onal detector during the readout.

### Background Art

Among others, WO 99/57719 teaches a method and apparatus, where two-dimensional data arrays are holographically recorded and read out. The practical implementation of such systems causes several problems. One such problem is the exactness of the re-inserting of a removable-displaceable data storage medium, which greatly influences the success of the readout. It is very difficult, or often not possible to ensure that the individual image pixels of the readout bitmap image falls always exactly on one and only one detector pixel. This problem is particularly serious when the re-inserted medium is rotated with a small angle relative to its original position, and the readout image will also be rotated on the readout detector. Due to the imaging errors in the optical system, the distance between the single image pixels may also vary in different parts of the image space. The large data density necessitates the use of detectors and data sources with a large number of pixels, and therefore even a rotation with a small angle results in the "creeping off' of certain image points of the bitmap image from the detector pixels, or sticking over to the other row or column, and therewith the regeneration of the data is very difficult, or impossible. For this reason, an appropriate algorithm is necessary for determining the associated data source image point for an image point of the readout bitmap.

It is a further problem that in the course of the writing (recording) and readout of tightly spaced holograms, the edge of the imaging beam also falls on the neighbouring holograms (so called inter-page interference). To avoid this, the disturbing beams should be filtered out in the plane of the holograms with an appropriate aperture. This can not be realised in practice.

EP-A-0 817 201 discloses a method according to the preamble of claim 1.

The object of the invention is to provide a solution to the above problems, or at least their partial elimination.

### Summary of the Invention

According to the invention, the problem caused by the re-inserting (re-positioning) is solved by a method according to claim 1 and being of the type described above, and wherein
a, the data to be recorded are coded with a coding which prohibits the immediate succession of data with identical states above a predetermined number of times,
b, in the matrix of the data source arrays of a predetermined size and position are defined, the arrays containing identifying data marks and user data marks,
c, the size of the identifying array is determined in such a manner so that the coding does not generate within an array containing user data marks such data sets, which would contain data marks identical in size and state to the data marks of the identifying array, and
d, the identifying arrays are filled with identifying data marks having identical states.

Preferably, the data are coded in a manner so that the image of a single data source matrix element contains at least one, but preferably more data bits, advantageously 1 byte, which is coded with a grey scale.

According to the invention, it is suggested that the readout of data from a medium containing data marks recorded with the inventive method is performed with the following steps:
searching for the identifying arrays, and determining their position, and
determining the position of the arrays containing the data marks relative to the identifying arrays.

It has proved to be particularly advantageous, if the number of the matrix elements of the detector along one dimension is chosen to be a multiple of the number of the matrix element of the data source, preferably 2-5 times thereof. In this case it is foreseen that the array of the detector matrix elements belonging to a matrix element of the data source is identified, and the value detected by a detector element or elements in a central region of an array thus identified is considered as the readout value. This has the advantage that the least noisy, and error-ridden data are filtered out from an oversampled large data set, and a data reduction by a factor of 10-100 is performed.

Further, according to the invention there is suggested a method for avoiding the crosstalk between the holograms, in the sense of the method mentioned in the introduction, where during the imaging, beside the Fourier-plane of the hologram, in the imaging setup a further Fourier-plane is established between the data source and the hologram, and in the further Fourier-plane spatial filtering is performed. Preferably, the spatial filtering is performed with an aperture. For providing a compact optical system, it has shown to be particularly advantageous if a mirror were placed in the further Fourier-plane, and the aperture were constituted by the mirror.

The invention also concerns an apparatus for the holographic recording and readout of data, particularly for implementing of the spatial filtering solution suggested by the invention. The inventive apparatus comprises a two-dimensional data source, and
an optical system for imaging the data source through an object beam and reference beam onto an optical medium and for establishing an interference of the object beam and the reference beam on the medium. The optical medium is positioned in the Fourier plane associated with the image of the data source. in the sense of the invention, beside the Fourier plane of the hologram, the optical system comprises a further Fourier plane between the data source and the hologram, and there is spatial filtering means in the further Fourier plane.

Advantageously, the optical system further comprises a further image plane associated to the data source as an object, and also comprises neutralising means for at least partly neutralising the Fourier peaks caused by the periodicity of the data source and the diffraction of the aperture of the data,source. Preferably, the neutralising means is a random phase mask.

### Brief Description of Drawings

The invention will be now explained in more detail with reference to the enclosed drawings, which show non-limiting embodiments of the invention.
- Fig. 1: is a perspective view of a card used in the apparatus performing the data organising method of the invention,
- Fig. 2: is a side and top view of the card shown in Fig. 1,
- Fig. 3: shows the structure of the medium of the card show in Fig. 1 in cross section,
- Fig. 4a-d: illustrates certain details of the data structure used on the medium,
- Fig. 5: is a principal drawing showing the optical system realising the imaging improvement method of the invention, and
- Fig. 6a-b: is a principal drawing of the ray propagation of the object beam and the reference beam in the optical system shown in Fig. 5,
- Fig. 7: illustrates the optical system of a readout head, using the imaging improvement method,
- Fig. 8: is a schematic optical layout of a modified optical system similar to that of Fig. 5,
- Fig. 9: is a schematic illustration of a polarising layer in the optical system of Fig. 5,
- Fig. 10: is a schematic illustration of the detector used in the optical system of Fig. 8,
- Fig. 11: is an alternative embodiment for the detector shown in Fig.10,
- Fig. 12 and 13: illustrate the proportions of the data source and the detector in the optical system used to perform the data organising method of the invention.

### Best Mode for Carrying out the Invention

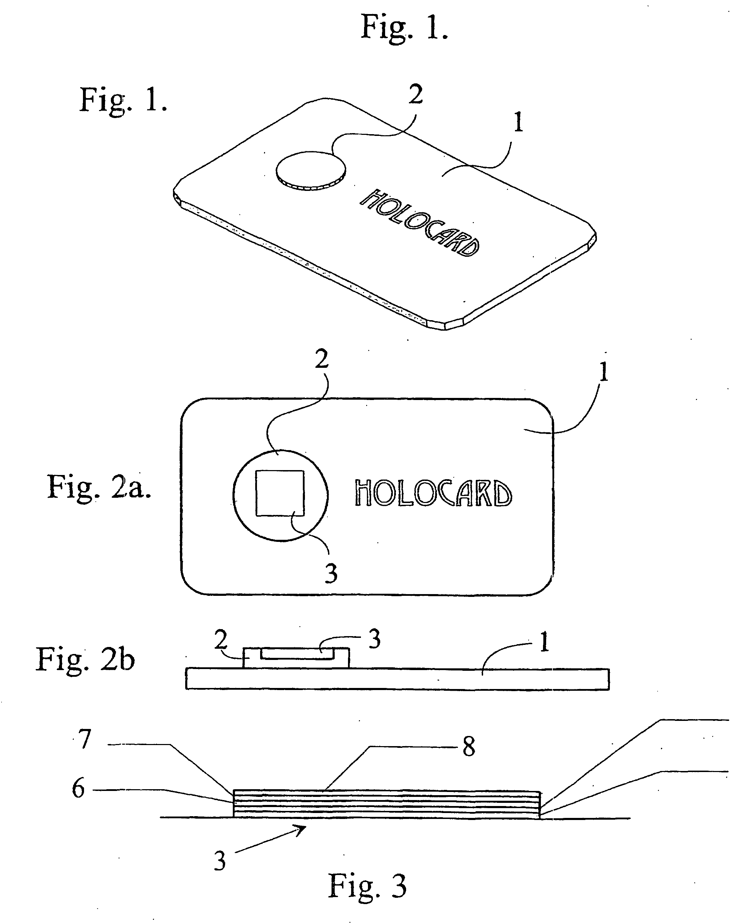

The data organising method embodying the invention will be explained with a data structure used on the optical card 1, which is shown in Fig. 1. The card 1 has an optical medium 2, which is suitable for holographic recording. The optical medium 2 also serves as a mechanical base layer, which carries an optical layer structure 3. The specific physical data storage medium is actually the optical layer structure 3. The optical card 1 is recorded and read by an optical recording apparatus, which is not shown here. The apparatus comprises a suitable write/read optical unit. Certain details of the write-read optical unit will be explained below, together with the explanation of the second inventive method.

The card 1 may be multiply written (recorded), read and erased, which latter is ensured by the material of the storage layer in the optical layer structure 3. There is a separate carrier (substrate) layer 5 within the optical layer structure 3 on the optical mediium 2. The carrier layer 5 provides an optical quality surface, and it is attached to the surface of the card with a bonding layer 4. The carrier layer 5 is covered with a mirror layer 6, the storage layer 7 and the protective layer 8. The card 1 is sized as a standard credit card, but other sizes are also applicable. In the figures, the layer structure 3 stands out from the plane of the card 1, but it is not necessary. Optionally, the top layer of the layer structure 3, i.e. the protective layer 8 may completely flush with the plane of the card 1, or may be even below this plane. In this case the medium 2 is sunk into the card 1.

Around the square 10 reserved for the writing, there is a frame 11 approx. 0,5 millimetres wide. The frame 11 serves the positioning of the card 1, as will be explained later. Beyond the positioning frame 11 there is a further region 12, also approx. 0,5 millimetres wide, where the optics may still move when searching for the positioning frame 11. The regions outside the square 12 on the medium 2 are not used. The size of the square 12 is approx. 12 x 12 millimetres. The mechanical and optical tolerances prescribed for the medium 2 should be kept within this area of 12 x 12 millimetres. It is also sufficient to make the optical layer structure 3 within the square 10, and the layers structure 3 need not extend beyond the borders of the square 10.

The data are stored in the system organised into blocks 13 (pages). Each block 13 consists physically of a single hologram 9, which is recorded with a single writing pulse. The optical system records or reads simultaneously a complete block 13. The data are organised in a simple file structure within the blocks 13.

Within the square 10, the blocks 13 are arranged geometrically in a predetermined manner. In the present case a square matrix arrangement is shown, which practically fills out the square 10. However, the blocks 13 may be of other form, e.g. hexagonal, and thus they may fill out the complete medium 2 in a honeycomb fashion.

Preferably, a block 13a is reserved for the storage of the actual system data of the card, which block 13a is positioned in a well-defined location, e. g. in a comer of the recordable area. This is the so-called description block, which contains the data relating to the card 1, as the blocks recorded during each writing operation, and the faulty blocks. The blocks recorded beside each other at the same time constitute a simple file system, and the name, length and physical location of the files is recorded in the description block. When inserting the card 1, the system first reads this block, and if the card has been recorded on, then the system deletes and rewrites this data block. The control program protects the areas already recorded.

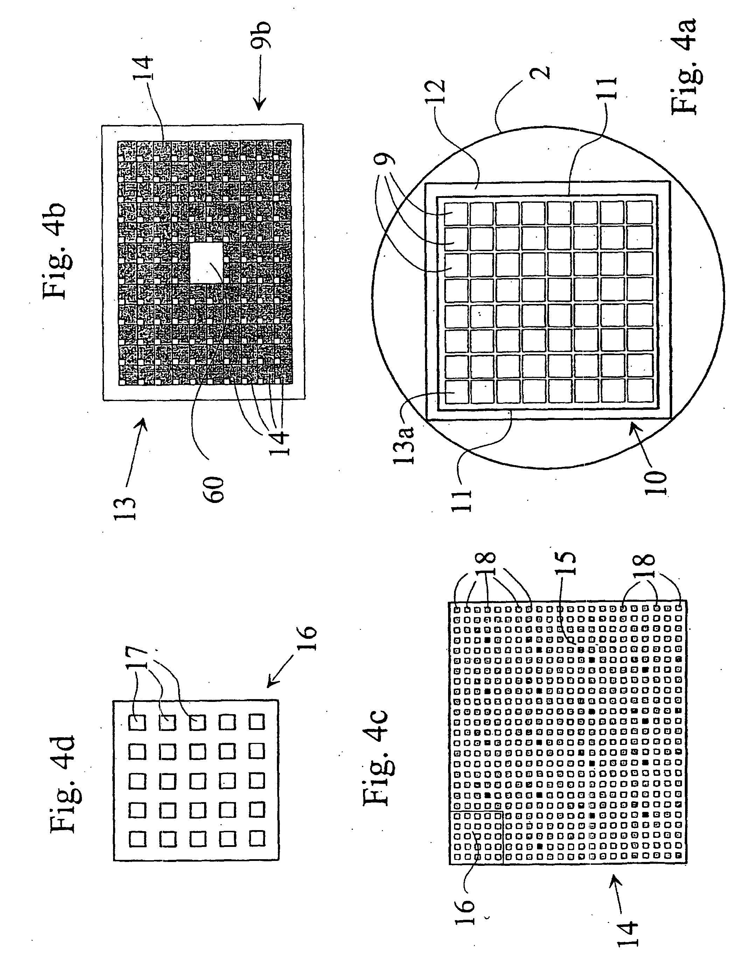

The first inventive concept concerns essentially the distribution of the data of such a block 13, which is recorded with a single hologram 9. This is illustrated in Figs. 4b, 4c and 4d. According to the invention, the data is coded with data marks having at least two states, with other words, the image pixels stored in the hologram represent at least one bit. It is most easy to detect these, because the detected light intensity associated to an image pixel need only be compared with a threshold value. With a holographic material having a greater dynamic range and/or smaller scattering, it is theoretically possible to store several bits in a single image pixel. As shown in Fig. 4c, in this embodiment a four-level grey scale is used (white, light grey, dark grey and black), which allows the storage of two bits in each image pixel. With an appropriate material it is possible to store up to 1 Byte in each image pixel.

Returning now to the structure of the data stored in the hologram 9, Fig. 4b and 4c show that the data were generated with a data source having a two-dimensional matrix structure. Fig. 4b may be regarded as the schematic illustration of the data source itself, or as the reconstructed image stored in the holograms 9 imaged on the detector of the write-read system, and appearing on the detector as an image (intensity distribution). The two-dimensional data source is an SLM (Spatial Light Modulator) matrix, the image of which is recorded on the optical medium, i. e. in the holograms on the card 1. During the readout, the image of the data source is regenerated with an optical method, and the regenerated image is detected with a two-dimensional detector having a matrix structure, i. e. the bitmap generated by the SLM is regenerated from the holograms, and it is imaged on a CCD detector. The task is to identity the location of the image pixels on the imaged bitmap, because it is necessary for the retrieval of the original data from the image thus generated.

Therefore, it is foreseen to proceed as follows: The data appearing in the bitmap generated by the SLM, that is the data to be directly physically recorded are coded with a coding which prohibits the immediate succession of data with identical states above a predetermined number of times. Among others, the known Hamming and Reed-Solomon error correction codes exhibit this property. This prevents the appearance of areas on the bitmap, which would consist of only dark or only light image pixels.

Further, in the matrix of the data source arrays of a predetermined size and position are defined, the arrays containing identifying data marks and user data marks. As it is clearly seen in Figs 4b and 4c, the total image 9b consists of several identical sub-blocks 14. In the central part of the block 13, four sub-blocks (2x2) are omitted, for reasons of the optical setup, which will be explained later. A larger part of the sub-blocks 14 consist of the data array 15, but an area in a comer of the sub-block 14 is designated as an identifying array 16. The actual data, i. e. the user data are stored in the data array 15. The size of the identifying array 16 is determined in such a manner so that the coding may never generate within a data array 15 such data sets, which could possibly contain data marks identical in size to data marks the identifying array 16, where all data marks would have identical states.

The identifying arrays 16 are filled with data marks having identical states. These are the identifying data marks, and no useful user data is associated with the identifying data marks. With other words, the image pixels 17 in the identifying arrays 16 have uniformly the same state, e. g. they are all light (see Fig. 4d). In the shown embodiment, the complete SLM matrix contains 320 x 240 pixels (image points or image pixels). Within those, an area of 300 x 200 pixels is used for data coding. The size of the sub-blocks 14 is 25 x 22 pixels, and an identifying array 16 consisting of 5 x 5 pixels is defined within those (in the upper left corner in the sub-block 14 shown in Fig. 4c).

The data distributed in this manner are read out according to the invention with a method, where the identifying arrays 16 are searched for and their position is determined, and thereafter the position of the data arrays 15 are determined relative to the identifying arrays 16. This is done by first searching with the optics for the frame 11, and thereby fixing the co-ordinate system of the optical system relative to the square 10 on the medium 2 of the card 1, with a certain accuracy. Thereafter, the movement and control system of the readout optics should be able to find a hologram with a certain address. The positioning accuracy of the readout optics is sufficient for the readout optics to find a 13 a block with an arbitrary address, and to image its content, i. e. the image of the stored hologram 9 onto the detector of the write/read system. Thereafter, a correlation algorithm identifies the location of the identifying arrays 16, which have a size of 5x5 pixels, and having a uniform content. More precisely, the correlation algorithm identifies those CCD detector pixels which are associated to the image points of the identifying array 16. Knowing the location of the identifying arrays 16, it is possible to calculate by linear interpolation from the data of the image points 17 of two neighbouring identifying arrays 16 the location of those CCD-detector pixels which are associated to the image points 18 between the two neighbouring identifying arrays 16.

It is preferable that the identifying arrays 16 should be close enough to each other, so that the distortion between two neighbouring identifying arrays 16 is small enough for the interpolation to define unequivocally the detector pixels associated to each image points 18.

If the rotation of the card is safely known to be small enough, then the location of the single image points 18 may be defined around an identifying array 16 based only on that single identifying array 16. In this case the identifying array 16 is defined not in a corner of the sub-block 14, but in its centre, because in this manner the distance is smallest from the given identifying array 16 to the image point 18 being farthest from the identifying array 16 from the position of which its location have been calculated. In a given case the location of the image points 18 may be determined so that its location is determined from two neighbouring identifying array 16, but independently from the position of the other identifying array, and if the distance between the two results remains within a predetermined value, the location between the two is considered as the real location. If the difference is too large, the card is mechanically re-positioned relative to the optics.

The accuracy of the readout may be greatly improved according to the invention, if the number of the matrix elements of the detector along one dimension is chosen to be a multiple of the number of the matrix elements of the data source, preferably 2-5 times thereof. This results in covering an image point restored from a hologram with a group of detector pixels.

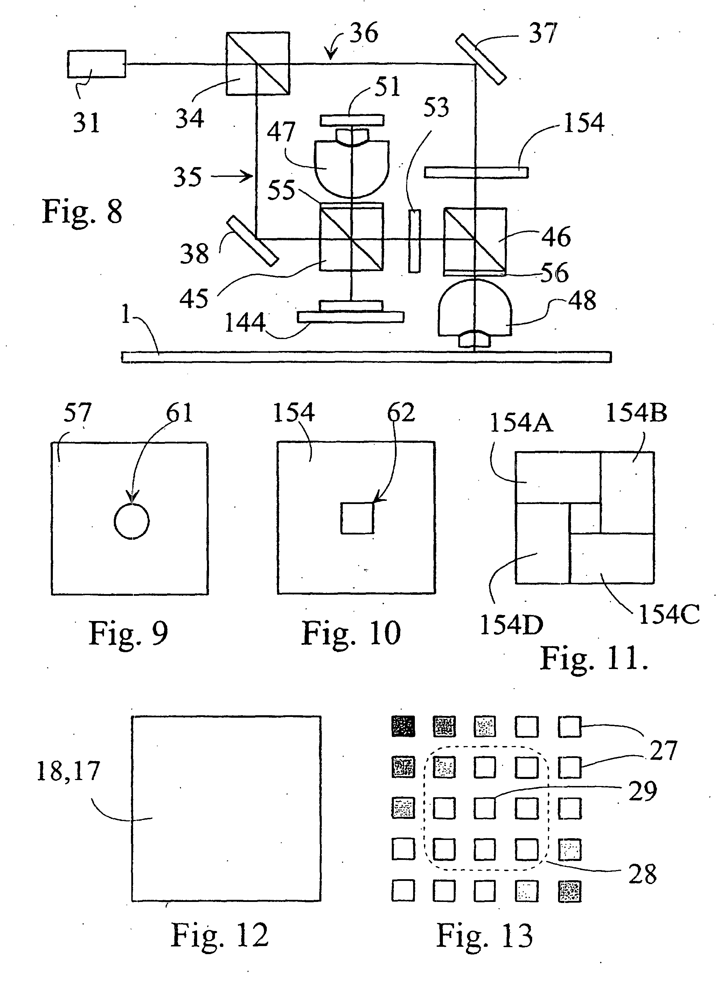

Therefore, it is foreseen to identify the array of the detector matrix elements belonging to a matrix element of the data source, particularly, the array of the detector matrix elements associated to the image points 17 of the identifying array 16. This may be done as the result of the correlation calculation performed to find the location of the identifying array 16, as mentioned above. The value detected by a detector element or elements in a central region of a pixel block thus identified is considered as the readout value. For example, if the number of the readout CCD detector pixels is five times of the number of the pixels of the data source SLM along one side (i. e. 5x5 = 25 times on the total surface), then a single image point 17 falls on an area of 5x5 pixels on the CCD detector. This is illustrated with reference to Figs. 12 and 13, which are on the same scale. An image of a data source image point 18 or 17 shown in Fig. 12 (practically, a single element of the data source SLM) is imaged on a group of pixels 27, see Fig. 13. Apparently, the data source image point 18 or 17 corresponds to a group of pixels 27 consisting of 5x5 pixels. Due to the inaccuracy of the imaging, the intensity value detected by the edge pixels may be rather uncertain. As shown in Fig. 13, the intensity detected by the corner pixels differs from the theoretical intensity value (in Fig. 13 the detected intensity is illustrated with the colour of the pixels 27). However, the inner pixel group 28 of 3x3 pixels is likely to detect a white image point only (in the shown example, only the upper right corner of the inner group 28 is affected with noise). The innermost single pixel 29 will practically safely detect the intensity of the associated image point. If the optical imaging is sufficiently good, at least a pixel set of 3x3 pixels may be identified from the theoretical pixel set of 5x5 pixels. Using the central pixel therefrom for the purposes of the linear interpolation, the CCD-pixels associated to the intermediate image points 18 may be determined with sufficient accuracy, at least so much that the central pixel of the detector pixel groups of 3x3 (or 5x5) pixels would indeed detect the intensity of the sought image point, where the pixel groups were associated to the image points by calculation.

As mentioned above, the holograms 9 containing the data are surrounded by the frame 11. During the search, first this frame 11 is found, and therewith the co-ordinate systems of the card and the moving system, and thus co-ordinate system of the optics fixed to the moving systems are associated with each other. Then we seek the identifying arrays 16 relative to a comer of the detector matrix. The identifying arrays 16 then identify the exact position of the images 9b reconstructed from the holograms 9.

The write/read unit is controlled by an external or internal microprocessor, which operates with a system software implementing the above method. The writing and reading commands, the data to be written and the area for writing is issued to the write/read system from the microprocessor. The error correction coding and decoding may be performed by the microprocessor, but it is more advisable to use a suitable dedicated hardware (e. g. for the Hamming and/or Reed-Solomon coding, in order to maintain an appropriate transfer rate). This dedicated hardware is responsible for improving the final data read BER (bit error rate) to a value of at least 10⁻¹² from a raw BER of approx. 10⁻²-10⁻³.

The write-read unit may contain a protection module which prevents the erasure of the data during readout. This may be necessary because with certain storage materials the reference beam may delete a part of the recorded signal during the readout. After a certain number of readouts, the signal level may deteriorate so that the data can not be read. The protection module is charged with the task of measuring the signal level of the holograms during the readout, and if the readout signal level should fall below a critical level, than the protection module proceeds to refresh (delete and re-write) the information in the hologram.

In the following, the method for the holographic recording and readout of data according to the invention is presented. This is a method where an image of a two-dimensional data source is recorded in a hologram on an optical medium. (In the example shown above, the two-dimensional data source is an SLM matrix.). The recorded hologram is resulting from an interference between an object beam and reference beam in a Fourier-plane associated to the image of the data source. In the present case the optical medium is the optical card 1. During the readout, the recorded hologram 9, more precisely, the image 9b restored from the hologram 9, is detected wiith a two-dimensional detector. According to the inventive method, beside the Fourier-plane of the hologram, a further Fourier-plane is established between the data source and the hologram in the imaging setup. In this further Fourier-plane spatial filtering is performed. The invention is illustrated by presenting the apparatus for implementing the method.

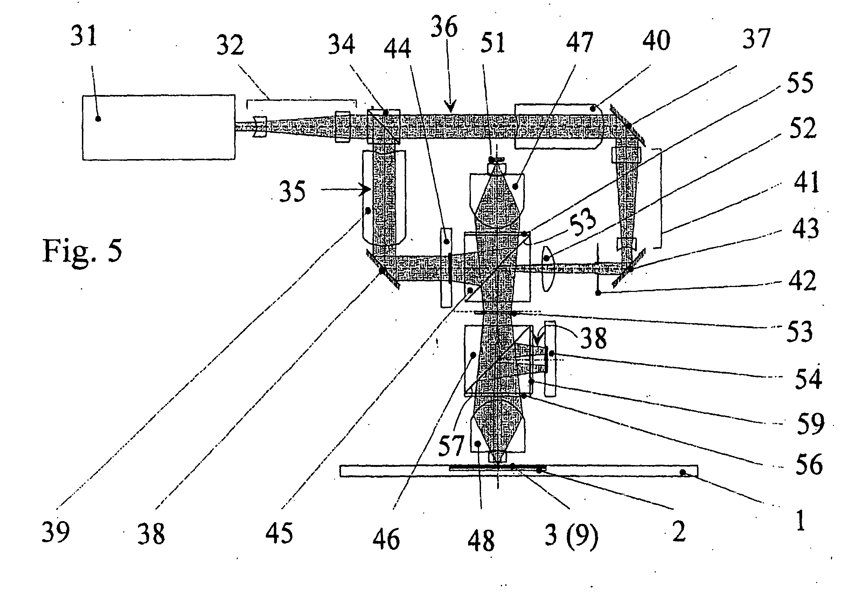

The write/read unit of the card write/read system, which was mentioned in the above example, and which is not shown here in more detail, comprises the optical system, which is shown schematically in Fig. 5. The light source of the optical system is constituted by a laser 31, in the present example a green diode laser. The beam of the laser 31 has a Gaussian distribution, and the beam is expanded by a spherical beam expander 32 to an appropriate size. In order to achieve a better wavefront, it is also possible to apply spatial filtering in this location with the pinhole method.

Instead of a green laser, a blue diode laser is also contemplated, particularly a DPSS (Diode-Pumped Solid State) laser.

The beam is divided into two beams with appropriate intensity by the neutral beam splitter cube 34, namely into an object beam 35 and a reference beam 26.
Optionally, the intensity ratio between the object and reference beams may be modified with the division ratio of the beam splitter cube 34.

The object beam 35 and the reference beam 36 propagates along the sides of a rectangle, and the opposing sides of the rectangle constitute the two arms of an interferometer. The beam diversion on the three corners of the rectangle is made by the plane mirrors 37,38 and 40, having dielectric mirror layers. With the appropriate adjustment of the side lengths of the rectangle, the equal length of the optical path of the object and reference beams until the layer structure 3 may be ensured.

In the object beam arm, the expanded object beam 35 having a Gaussian distribution is transformed into a homogenous plane wave with the beam forming optics 39. This latter is a single piece lens with two aspheric surfaces. Similarly, in the reference arm the expanded Gaussian beam is transformed into a homogenous plane wave with the beam forming optics 40. The homogenous beam is compressed to the appropriate size with a spherical beam converter 41. Optionally, the aspheric beam forming optics 40 may be omitted, or substituted by a plane parallel plate, which allows the use of an illuminating beam having a Gaussian profile in the reference arm. In this case this factor must be taken into consideration when the beam converter 41 is designed.

In the reference arm, there is a further mirror 43 following the beam converter 41, followed by a square aperture 42. The aperture 42 is imaged onto the card 1 with the reference beam 36. In the present case the used aperture 42 has the form of a square, but apertures in the form of a circle or other shape could be equally applicable.
The coupling of the object beam 35 and the reference beam 36 is done along one side of the rectangle. The object beam 35 is coupled onto the SLM 44 with the mirror 38. The SLM 44 constitutes a two-dimensional data source ( in the presented embodiment an LCD-based transmission mode SLM is used). The hologram of the active area of the SLM 44 is recorded on the card 1, in the recording layer 7 of the layer structure 3.

The optical axis of the Fourier holographic optics, which provides an object/image imaging, is perpendicular to the beams illuminating the 44 SLM and the aperture 42. The SLM 44 constitutes the object of the holographic optical system, while the aperture 42 serves as the reference of the holographic optical system.

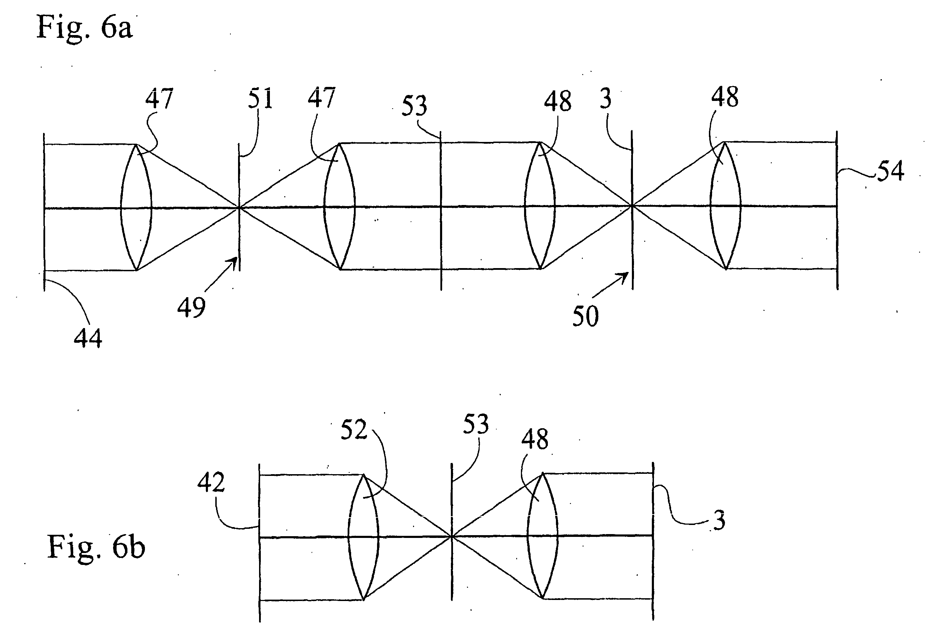

The principle of this Fourier holographic system is shown in a folded-out position in Figs. 6a and 6b. The object/image arm, which is constituted by the object beam 35, is realised as a so-called 8f system, and it is shown in Fig. 6a. This object arm also comprises the polarising splitter prisms 45 and 46 (the polarising splitter prisms are not shown in the Figs. 6a and 6b, because they have no role in the imaging itself, but only serve the coupling of the object and reference beams into the optical path. The write/read system comprises two identical Fourier objectives 47 and 48. There is a mirror in each Fourier plane (focal plane) 49 and 50 of the Fourier objectives 47 and 48, so in this manner it is possible to use only two Fourier objectives for the 8f system, instead of the four objectives that are theoretically required. The first mirror is the mirror 51, which is also used as the spatial filtering means. The other mirror is the hologram 9 itself, which is recorded in the layer structure 3 of the holographic card, and the mirror layer 6 below the hologram 9 in the layer structure 3 (see also Fig. 3.). As it is apparent from Fig. 5, the splitter prisms 45 and 46 are between the two Fourier objectives 47 and 48.

The reference arm, which is constituted by the reference beam 36, is a so-called 4f system (see also Fig. 6b), which images the image of the reference aperture 42 onto the hologram 9. The system comprises two Fourier objectives, which are different in design and focal length. The first Fourier objective 52 is a single piece optics, and it is located between the reference aperture 42 and the coupling polarising splitter prism 45. The second objective is common with the second Fourier objective 48 of the object/image arm. With the appropriate selection of the focal lengths of the Fourier objectives 52 and 48, the reference aperture 42 may be imaged onto the holographic card 1 with suitable magnification or reduction.

The object beam 35 and the reference beam 36 is coupled together though the first polarising splitter prism 45. The polarising splitter layer 53 deflects the object beam 35 upwards, towards the first Fourier objective 47, while the reference beam 36 is directed downwards, towards the common focal plane of the Fourier objectives 52 and 48.

The SLM 44 constituting the object is positioned in the first focal plane of the optical imaging system embodied by the first Fourier objective 47. A mirror 51 is placed in the rear focal plane, in the so-called Fourier plane. In the presented embodiment the mirror 51 is a plane mirror of with a predetermined size. Compared with the previously known solutions, the optical system was modified by creating a further Fourier plane, beside the necessary Fourier plane for creating the hologram itself. This further Fourier plane is formed before the hologram on the optical path. The mirror 51 is placed in this further Fourier plane.

During the writing of the holograms, the mirror 51 serves as a spatial filtering means in the holographic optical system, with other words, as the aperture diaphragm. The importance of this spatial filtering means lies in the fact that it substitutes in effect an aperture in the plane of the hologram 9, where otherwise it is not possible to place an aperture, due to the dimensional constraints of the optical system. Thereby the mirror 51 as a limiting aperture reduces the light falling on the neighbouring holograms. With other words, this spatial filtering reduces the so-called inter-page interference. Beside, the aperture effect contributes to the filtering out of scattered light, and also limits the cone angle of the recording object beam.

As a further benefit; with suitable sized mirror 51 and appropriately designed optical system, the disturbing Fourier components may be filtered out from the object beam 35. For example, the periodic structure of the SLM 44 appears as a grid in the imaging optics. This grid causes large peaks in the Fourier plane. If these large peaks falls on the hologram, they significantly decrease the achievable SNR of the hologram. However, it is possible to filter out some of these large peaks with the mirror 51.

It is a further advantage that this spatial filtering also influences the achievable data density, because the size of the mirror 51 is exactly equal to the size of the recorded hologram. With other words, a smaller mirror results in a smaller hologram. With an equal sized SLM, a smaller hologram means larger data density. Of course, there is an upper limit to the data density achievable with this method, because the resolution of the imaging is also decreased with the filtering out of the Fourier components.

Finally, it must be mentioned that the system allows the design of an optical system having two completely identical Fourier objectives. Therefore, the specific manufacturing costs of the optical system may be smaller. Generally, the splitter prisms also have a simpler construction, as compared with the known solutions, e. g. the optical system known from WO99/57719.

The Fourier-objectives 47 and 48, the mirror 51 and the hologram 9 constitutes a symmetrical optical system, and in the middle part of this system (between the polarising splitter prisms 45 and 46) a real image of the SLM 44 is created. In this image plane a random distribution phase mask 53 is placed, with a pixel arrangement. The position, size and number of the pixels of the phase mask 53 is the same as the corresponding data of the SLM 44. The phase mask 53 adds a random phase shift in the object beam 35, which is changing at every pixel. With this phase mask 53 the appearance of the large Fourier components is prevented, which would result from the periodicity of the bitmap image written onto the SLM 44, and those large components are also eliminated, which results from the diffraction on the aperture of the SLM 44, appearing around the zero spatial frequency.

The Fourier transform of the aperture 42 in the reference arm appears in the middle of the phase mask 53. For this reason, there is no phase modulation in a central region of the phase mask 53.

However, it is also possible to use for the Fourier filtering of the reference beam 36 a second phase- and/or amplitude mask on the surface of the phase mask 53, so that this second mask is independent from the "peripheral" phase mask used by the object beam 35.

Following the phase mask 53, the object and reference beams propagate through the second polarising splitter prism, and the second Fourier objective 48, in order to generate/reconstruct/erase the hologram on the card. During readout, the reconstructed image of the hologram 9 is imaged through the second Fourier objective 48, and it is deflected towards the detector matrix by the second polarising splitter prism 46. The detector matrix or array is realised in this embodiment by the CCD detector matrix 54. After the polarising splitter prisms there are λ/4 plates 55 and 56, which perform a linear-circular, and circular-linear polarisation transformations, respectively. Thereby the light going through the λ/4 plate 55, being reflected on the mirror 51, and again going through the λ/4 plate 55 will have a linear polarisation, perpendicular to its previous state of polarisation.

In the polarising layer 57 of the second splitter prism 46, which is closer to the card 1, there is a small central region 61 without a splitter layer. This also shown in Fig. 9. This central region 61 serves for the lead-through of the reference beam 36. In this manner the reference beam 36, which propagates towards the card 1 with an orthogonal polarisation relative to the object beam 35, will go through the splitter layer 57 without reflection. With other words, there is a separate channel in the optics for the propagation of the reference beam 36, and this channel comprises two principal elements: the non-modulating region 60 in the centre of the phase mask 53, and the region 61 without the splitter layer formed in the polarising splitter layer 57 of the polarising splitter prism 46.

The reference beam 36, which is reflected from the card 1 without diffraction, and other components thereof reflected from the lens surfaces will not reach the detector, because these will pass twice through the λ/4 plate. Even so, a further polarising filter may be placed before the CCD detector matrix 54, in order to filter out eventual scattered light.

In the optical system the state of polarisation of the various beams are as follows: The light is emitted from the laser 31 with linear polarisation. This polarisation is initially unchanged as linear polarisation, both in the object arm and in the reference arm.

Following the first λ/4 plate 55, the light turns circularly polarised, and following the first polarising splitter prism 45, the object beam 35 and the reference beam 36 will be linearly polarised, perpendicularly to each other. After the second λ/4 plate 56 the object beam 35 and the reference beam 36 will be circularly polarised; again perpendicularly to each other. The object beam 38 returning from the hologram will be linearly polarised after the second polarising splitter prism 46.

As mentioned above, in order to determine the position of the holograms 9, there is a positioning frame 11 outside the data area on the holographic storage card 1. When the card 1 is inserted, the read hed measures the position of the frame 11, and this is considered as the frame of reference during movement. The position of the individual holograms 9 to be recorded are determined relative to this frame 11, and during readout, the search for the other recorded holograms 9 is done relative to the frame 11. This frame 11 may have a non-reflective surface in a reflecting background, or the frame 11 may be reflecting with a non-reflecting background. During the search for the positioning frame 11, only the central region 60 of the SLM 44 is used (see also Fig. 4b). The pixels in the central region 60 are those, which are imaged onto the central region of the phase mask 53, i.e. onto the region where the reference beam 36 goes through. During the search for the frame 11, these pixels are turned "on", i. e. full light intensity is going through the pixels. Since there is no phase modulation in the central region of the phase mask 53, there will be a sharp focal point (a Fourier peak) on the card 1. This focal point is determined by the illuminated central region 60 of the SLM 44. The diameter of this focal spot is approx. 5-10 µm. The search for the frame 11 is done with the help of this focal spot, in the following manner: Moving the focal spot across the frame 11, the total intensity falling on the detector matrix is monitored. When the focal spot of the optical system reaches the frame 11, the total intensity measured on the CCD 54 will significantly increase (or decrease, depending on the design of the frame 11 and its background). The position of the frame 11 may be determined with great accuracy (± 2 µm), based on the maximal total intensity measured by the CCD detector matrix 54 in the different points of the medium 2 on the card 1.

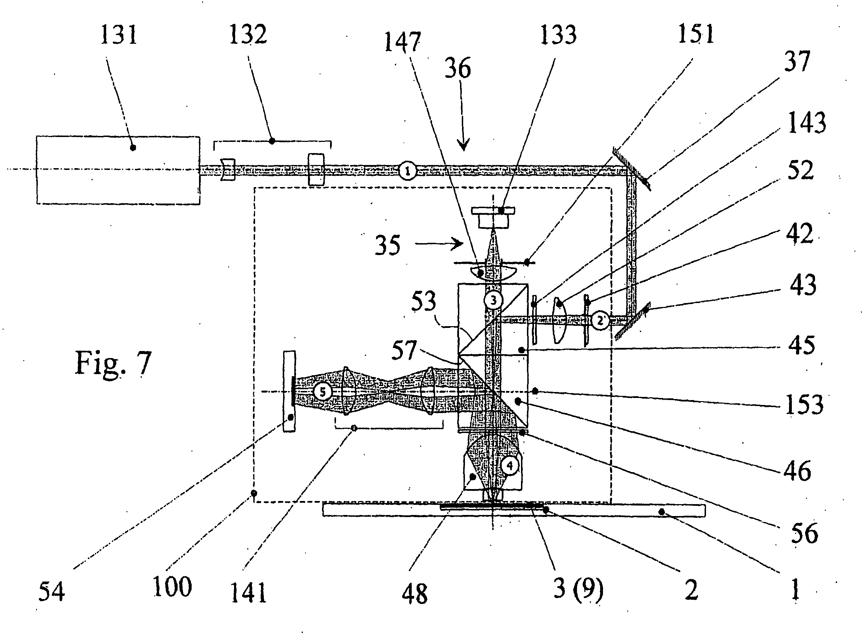

Fig. 7 shows the optical system of a readout head which is used to read information stored on the optical card 1. This system is different from the one shown in Fig. 5 in several respects. Firstly, there is no object arm, and therefore there is no SLM. This optical system is used for readout only. Secondly, a separate laser is used for positioning the optical head relative to the optical medium.

The reference beam 36 is coupled onto the holograms 9 in a similar manner as in the optical system above, i. e. with the help of a polarising splitter prism 46 having a polarisation layer 57 with a central region 61, where the central region 61 is without polarisation properties (see Fig. 9).

The optical system of Fig. 7 works as follows:
The reference laser module 131 emits a Gaussian beam, which may be expanded to appropriate size by an optional beam expander 132. This beam is linearly polarised, with appropriate direction, so that the reference beam 36 will be reflected on the polarising layer 53 of the splitter prism 45. The reference beam is deflected into the reference aperture 42 by the mirrors 37 and 43. The reference aperture 42 has a rectangular diaphragm, however, other forms are also applicable. Typically, circular apertures are also usable.

The collimated reference beam is focussed into the focal plane 153 of the Fourier objective 48 with the spherical lens 52. Following the lens 52 a plane parallel plate 143 is used to adjust optical axis of the reference beam 36. This is done by slightly tilting the plane parallel plate 143. In this manner the optical axis of the reference beam 36 may be adjusted with great accuracy.

There is a separate laser diode 133, which is used solely for the searching of the frame 11 during the initial setup, described above with reference to Fig. 5. Since the reference beam 36 is not focussed on the medium 2 of the card 1, in the absence of the object beam there is need for an other light source which is focussed on the plane of the frame 11 by the lens 147. An aperture 151 limits the beam size of the search beam.

The beam of the laser diode 133 is linearly polarised, with appropriate direction, so that the search beam 35 will be transmitted through the polarising layer 53 of the splitter prism 45.

The search beam 35 and the reference beam 36 is coupled together with the polarising splitter prism 45. The polarising layer 53 transmits the search beam 35, while deflects the reference beam 36 towards the card 1.

The reference arm is realised as a 4f optical system, which images the image of the reference aperture 42 onto the holograms 9. The system comprises two different Fourier objectives, with different focal length. The first objective 52 is a single element lens, between the aperture 42 and the coupling prism 45. The second objective is common with the second objective 48 of the object/image arm of the 4f system. With suitable selection of the focal lengths of the Fourier objectives, the reference aperture may be imaged onto the holographic card I with the desired magnification.

The reference beam 36 is collimated by the Fourier objective 28, in order to generate a plane wavefront on the card. The image of the reference aperture 12 will function as the diaphragm on the card.

Following the first splitter prism 45, the search beam 35 and the reference beam pass through the second splitter prism 46 (the search beam is used only during the position setup, i.e. when the frame 11 is found and located). The reference beam is reflected from the hologram 9, and the stored image in the hologram is reconstructed. The reflected beam passes once more through the second splitter prism 46, and it is deflected towards the detector matrix 54, while the reference will pass through the central region 61 of the polarising layer 57. A relay lens system 141 is used to position the detector matrix 54 in a convenient distance from the splitter prism 46.
Below the second splitter prism 46, there is a λ/4 layer 56, which performs a linear-circular, and on return a circular-linear polarisation transformation. As a result, the beam leaving the splitter prism 46 will be linearly polarised, perpendicularly to its previous polarisation direction.

From the above it is apparent that there is a separate channel in the optical system for the reference beam 36, similarly to the setup shown in Fig. 5.

Fig. 8 shows a modified embodiment of an optical system, which functions similarly to the system of Fig. 5. This is an optical system containing both an object beam 35, and a reference beam 36, but the data source is a reflection mode SLM 144. Therefore, it is not possible to couple the object beam 36 into the system through the SLM 144. Instead, the first splitter prism 45 is used for this purpose. Accordingly, the refernce beam 36 must be coupled into the system elsewhere. In the proposed embodiment, a detector matrix 154 is used for this purpose. This detector matrix 154 comprises an opening 62 in a central region, where the reference beam 36 can pass through. This is also an 8f system, with a spatial filtering element, the mirror 51 in one of the Fourier planes. In an intermediate image plane a random phase mask 53 is placed, with the same function as the mask 53 in Fig. 5. Some parts of the beam shaping optics are not shown in Fig. 8. The other elements having the same reference number are identical in function to those in Fig. 5.

The detector matrix 154 may be realised with four distinct rectangular detectors 154A-D, in the configuration shown in Fig. 11.

The invention is not limited to the shown embodiments. The data storage medium could be a disk or tape instead of the card, and the data identifying method according to the invention may be used with non-holographic optical data storage as well. The two-dimensional data source and the two-dimensional detector may have a number of suitable alternative embodiments, which are apparent for the skilled person, e. g. a micromirror device as data source, or a CMOS detector as the detector matrix. The identifying array need not be in a comer of the user data array, but may be in a central position. The aperture used for the spatial filtering in the further Fourier plane may have various shapes, e. g. rectangular, particularly square, or circular, hexagonal or other complex shape.

## Claims

1. Method for the readout of data from an optical data storage medium, wherein an image of a data source having a two-dimensional matrix structure is recorded in a hologram in an optical medium, so that data are coded with data marks having at least two states, where the data marks are generated by the data source with a method comprising the steps of
a, coding the data to be recorded with a coding which prohibits the immediate succession of data with identical states above a predetermined number of times,
b, defining identifying arrays and data arrays of a predetermined size and position in the matrix of the data source, the identifying arrays containing identifying data marks and the data arrays containing user data marks,
c, determining the size of the identifying array in such a manner so that the coding does not generate within a data array such data sets, which would contain data marks identical in size and state to the identifying data marks of the identifying array, and
d, filling the identifying arrays with identifying data marks having identical states, and
during readout, regenerating the image of the data source during readout with an optical method,
detecting the regenerated image with a two-dimensional detector having detector pixels, and
reading out the data from the regenerated image with the help of the identifying marks on the detected image, wherein the identifying arrays are searched for and their position is determined, and
determining the position of the arrays containing the data marks relative to the position of the identifying arrays,
**characterised in that** the method further comprises the steps of
calculating from the position of the identifying arrays the location of those detector pixels which are associated to the data marks of the data arrays,
retrieving the stored data from data marks with a detector pixel in the calculated pixel locations.

2. The method of claim 1, wherein the data marks are recorded in the medium as an image of a single data source matrix element, where a data mark contains at least two data bits, coded with grey scale.

3. The method of claim or 2, wherein
- the number of pixels of the detector along one dimension is chosen to be a multiple of the number of the matrix elements of the data source, and
- an array of the detector pixels associated to a matrix element of the data source is identified, and a value detected by a detector pixel or pixels in a central region of the array thus identified is considered as the readout value.

4. The method of claim 3, wherein the number of the pixels of the detector along one dimension is chosen to be 2-5 times of the number of the matrix elements of the data source.

5. The method of any one of claims 1 to 4, wherein the identifying arrays are searched for with a correlation determining method.

6. The method of any one of the claims 1 to 5, wherein the holograms containing the data are surrounded with a frame, comprising the steps of
- first searching for the frame, and
- searching for the identifying arrays which identify the exact position of the holograms relative to a predetermined point of the frame.

7. The method of claim 6, wherein a search beam is generated by focusing image points of the data source onto the storage medium.

8. The method of claim 7, wherein the readout is performed with an optical system comprising
a random phase mask for at least partly neutralising the Fourier peaks caused by the periodicity of the data source and a diffraction of the aperture of the data source, the phase mask comprising a centrally positioned region, where this central region is devoid of phase modulation, and
a polarising beam splitter, the beam splitter comprising a polarising layer, and the polarising layer comprising a central region without polarising and/or splitting properties,
the method further comprising the step of directing the search beam through the central region of the phase mask and the central region of the polarising layer.

9. The method of claim 8, wherein the positioning frame is placed in a Fourier plane of the optical system of the search beam, and the crossing of the positioning frame is detected by monitoring the total intensity of the reflected search beam, and detecting a sharp change in the monitored intensity.

10. The method of any one of the claims 1 to 9, wherein the identifying arrays are arranged as close to each other so that an imaging distortion between two neighbouring identifying arrays is not larger than an error of an interpolation, the interpolation defining the location of the detector pixels associated to image points.

## Patentansprüche

1. Verfahren zum Auslesen von Daten aus einem optischen Datenspeichermedium, bei dem ein Bild einer Datenquelle mit einer zweidimensionalen Matrixstruktur in einem Hologramm in einem optischen Medium aufgenommen wird, so dass Daten mit Datenmarkierungen, die mindestens zwei Zustände besitzen, codiert werden, wobei die Datenmarkierungen von der Datenquelle mit einem Verfahren erzeugt werden, das die folgenden Schritte aufweist:
a) Codieren der aufzunehmenden Daten mit einer Codierung, die die unmittelbare Aufeinanderfolge von Daten mit identischen Zuständen oberhalb einer vorbestimmten Anzahl verhindert,
b) Definieren von Kennfeldern und Datenfeldern vorbestimmter Größe und Position in der Datenquellenmatrix, wobei die Kennfelder Kenndatenmarkierungen und die Datenfelder Benutzerdatenmarkierungen enthalten,
c) Bestimmen der Größe des Kennfeldes derart, dass die Codierung keine solche Datengruppen innerhalb eines Datenfeldes erzeugt, die Datenmarkierungen enthalten, welche hinsichtlich ihrer Größe und ihres Zustandes identisch zu den Kenndatenmarkierungen des Kennfeldes sind, und
d) Auffüllen der Kennfelder mit Kenndatenmarkierungen, die identische Zustände besitzen, und
Wiederherstellen des Bildes der Datenquelle während des Auslesens mit einem optischen Verfahren,
Detektieren des wiederhergestellten Bildes mit einem zweidimensionalen Detektor, der Detektorpixel besitzt, und
Auslesen der Daten aus dem wiederhergestellten Bild mit Hilfe der Kennmarkierungen auf dem detektierten Bild, wobei nach den Kennfeldern gesucht und ihre Position bestimmt wird, und
Bestimmen der Position der Felder, die die Datenmarkierungen enthalten, relativ zu der Position der Kennfelder,
**dadurch gekennzeichnet, dass** das Verfahren des weiteren die Schritte aufweist:
Berechnen anhand der Position der Kennfelder, die Lage jener Detektorpixel, die den Datenmarkierungen der Datenfelder zugeordnet sind,
Abrufen der gespeicherten Daten anhand der Datenmarkierungen mit einem Detektorpixel in den berechneten Pixellagen.

2. Verfahren nach Anspruch 1, wobei die Datenmarkierungen in dem Medium als ein Bild eines einzelnen Datenquellen-Matrixelements aufgenommen werden, und wobei eine Datenmarkierung mindestens zwei mit Hilfe einer Grauskallierung codierte Datenbits enthält.

3. Verfahren nach Anspruch 1 oder 2, wobei
- die Anzahl der Pixel des Detektors entlang einer Achse derart ausgewählt ist, dass sie ein Vielfaches der Anzahl der Matrixelemente der Datenquelle ist, und
- ein Feld der Detektorpixel, das einem Matrixelement der Datenquelle zugeordnet ist, identifiziert wird, und ein Wert, der über ein Detektorpixel oder mehrere Pixel in einem zentralen Bereich des so identifizierten Feldes detektiert wird, als der Auslesewert angesehen wird.

4. Verfahren nach Anspruch 3, wobei die Anzahl der Pixel des Detektors entlang einer Achse das Zwei- bis Fünffache der Anzahl der Matrixelemente der Datenquelle ist.

5. Verfahren nach einem der Ansprüche 1 bis 4, wobei nach den Kennfeldern mit Hilfe eines Korrelations-Bestimmungsverfahrens gesucht wird.

6. Verfahren nach einem der Ansprüche 1 bis 5, wobei die Hologramme, die die Daten enthalten, von einem Rahmen umgeben sind, mit den Schritten:
- zunächst Suchen nach dem Rahmen, und
- Suchen nach den Kennfeldern, die die exakte Position der Hologramme relativ zu einem vorbestimmten Punkt des Rahmens identifizieren.

7. Verfahren nach Anspruch 6, wobei ein Suchstrahl dadurch erzeugt wird, indem Bildpunkte der Datenquelle auf das Speichermedium fokussiert werden.

8. Verfahren nach Anspruch 7, wobei das Auslesen mit einem optischen System durchgeführt wird, umfassend:
eine Zufallsphasenmaske zum zumindest teilweise Neutralisieren der Fourier-Spitzen, die durch die Periodizität der Datenquelle und eine Beugung der Apertur der Datenquelle hervorgerufen werden, wobei die Phasenmaske einen zentral gelegenen Bereich aufweist und in diesem Bereich keine Phasenmodulation stattfindet, und
einen Polarisationsstrahlteiler, wobei der Strahlteiler eine Polarisationsschicht aufweist und die Polarisationsschicht einen mittleren Bereich aufweist, der keine Polarisations- und/oder Teilereigenschaften besitzt,
und das Verfahren ferner den Schritt des Richtens des Suchstrahles durch den mittleren Bereich der Phasenmaske und den mittleren Bereich der Polarisationsschicht aufweist.

9. Verfahren nach Anspruch 8, wobei der Positionierrahmen in eine Fourier-Ebene des optischen Systems des Suchstrahles platziert wird, und wobei das Kreuzen des Positionierrahmens dadurch detektiert wird, indem die Gesamtintensität des reflektierten Suchstrahles überwacht und eine abrupte Änderung der überwachten Intensität detektiert wird.

10. Verfahren nach einem der Ansprüche 1 bis 9, wobei die Kennfelder derart eng aneinander angeordnet sind, so dass eine Bildverzerrung zwischen zwei benachbarten Kennfeldern nicht größer als ein Interpolationsfehler ist, und wobei die Interpolation die Lage der Detektorpixel bestimmt, die den Bildpunkten zugeordnet sind.

## Revendications

1. Procédé pour la lecture de données à partir d'un support de mémoire de données optiques, dans lequel une image d'une source de données présentant une structure matricielle bidimensionnelle est enregistrée selon un hologramme dans un support optique, de telle sorte que des données soient codées avec des marques de données présentant au moins deux états, dans lequel les marques de données sont générées par la source de données avec un procédé comprenant les étapes de :
a) codage des données à enregistrer avec un codage qui empêche la succession immédiate des données avec des états identiques au-dessus d'un nombre de fois prédéterminé ;
b) définition de réseaux d'identification et de réseaux de données d'une dimension prédéterminée et d'une position prédéterminée selon une matrice de la source de données, les réseaux d'identification contenant des marques de données d'identification et les réseaux de données contenant des marques de données d'utilisateur ;
c) détermination de la dimension du réseau d'identification de telle sorte que le codage ne se génère pas à l'intérieur d'un réseau de données tel que des jeux de données, qui devrait contenir des marques de données identiques en dimension et en état aux marques de données d'identification du réseau d'identification ; et
d) remplissage des réseaux d'identification avec des marques de données d'identification présentant des états identiques ; et
pendant la lecture, génération de l'image de la source de données pendant la lecture avec un procédé optique ;
détection de l'image régénérée avec un des lecteurs bidimensionnels présentant des pixels de détecteur ; et
lecture des données à partir de l'image régénérée à l'aide des marques d'identification sur l'image détectée, dans lequel les réseaux d'identification sont recherchés et leurs positions sont déterminées ; et
détermination des positions des réseaux contenant les marques de données par rapport aux positions des réseaux d'identification ;
**caractérisé en ce que** le procédé comprend en outre les étapes de :
calcul à partir des positions des réseaux d'identification de la localisation des pixels de détecteur qui sont associés aux marques de données des réseaux de données ; et
récupération des données stockées à partir des marques de données avec un pixel de détecteur dans les localisations de pixel calculées.

2. Procédé selon la revendication 1, dans lequel les marques de données sont enregistrées dans le support en tant qu'une image d'un élément de matrice de source de données unique, dans lequel une marque de données contient au moins deux bits de données codés avec une échelle de gris.

3. Procédé selon la revendication 1 ou 2, dans lequel :
le nombre de pixels du détecteur suivant une dimension est choisi de façon à être un multiple du nombre des éléments de matrice de la source de données ; et
un réseau des pixels de détecteur qui est associé à un élément de matrice de la source de données est identifié, et une valeur qui est détectée par un pixel ou des pixels de détecteur dans une région centrale du réseau ainsi identifié est considérée en tant que valeur de lecture.

4. Procédé selon la revendication 3, dans lequel le nombre des pixels du détecteur suivant une dimension est choisi de façon à être 2 à 5 fois le nombre des éléments de matrice de la source de données.

5. Procédé selon l'une quelconque des revendications 1 à 4, dans lequel les réseaux d'identification sont recherchés avec un procédé de détermination de corrélation.

6. Procédé selon l'une quelconque des revendications 1 à 5, dans lequel les hologrammes contenant les données sont entourés d'un cadre, comprenant les étapes de :
tout d'abord recherche du cadre ; et
recherche des réseaux d'identification qui identifient la position exacte des hologrammes par rapport à un point prédéterminé du cadre.

7. Procédé selon la revendication 6, dans lequel un faisceau de recherche est généré en focalisant des points d'image de la source de données sur un support de stockage.

8. Procédé selon la revendication 7, dans lequel la lecture est réalisée avec un système optique comprenant :
un masque de phase aléatoire pour au moins partiellement neutraliser les crêtes de Fourier qui sont provoquées par la périodicité de la source de données et une diffraction de l'ouverture de la source de données, le masque de phase comprenant une région positionnée centralement, dans lequel cette région centrale est dépourvue de modulation de phase ; et
un séparateur de faisceau de polarisation, le séparateur de faisceau comprenant une couche de polarisation et la couche de polarisation comprenant une région centrale sans polarisation et/ou des propriétés de séparation ;
le procédé comprenant en outre l'étape de direction du faisceau de recherche au-travers de la région centrale du masque de phase et de la région centrale de la couche de polarisation.

9. Procédé selon la revendication 8, dans lequel le cadre de positionnement est placé dans un plan de Fourier du système optique du faisceau de recherche et le croisement du cadre de positionnement est détecté en surveillant l'intensité totale du faisceau de recherche réfléchi et la détection d'un changement abrupt de l'intensité surveillée.

10. Procédé selon l'une quelconque des revendications 1 à 9, dans lequel les réseaux d'identification sont agencés de façon proche les uns des autres de telle sorte qu'une distorsion de production d'image entre deux réseaux d'identification voisins ne soit pas plus grande qu'une erreur d'interpolation, l'interpolation définissant la localisation des pixels de détecteur qui sont associés aux points d'image.
